# EUROPEAN PATENT APPLICATION

(11) **EP 0 599 591 A1**
(43) Date of publication of application: **01.06.1994**
(21) Application number: 93309312.2
(22) Date of filing: 23.11.1993
(51) Int. Cl.: H01L 23/66, H01L 23/36, H03F 3/50

(54) **Emitter follower transistor with improved thermal resistance characteristics**

(30) Priority: 25.11.1992 US 981818
(71) Applicant: SGS-THOMSON MICROELECTRONICS, INC., Carrollton Texas 75006 (US)
(72) Inventor: Bartola, Robert David, Chester County, PA 19464 (US)
(74) Representative: Palmer, Roger

(57) **Abstract**

It would be advantageous in the art to use common-collector, also known as emitter-follower, transistors in power amplifier applications. The collector of an emitter-follower transistor is mounted directly to the flange of the transistor. The thermal resistance from junction to case is greatly reduced by eliminating the use of an insulating material between the collector of the emitter-follower transistor and the flange of the device package. Elimination of the insulator also means that in addition to providing greater power saturation, the emitter-follower circuit may also be utilized to deliver a lower power saturation with increased device reliability.

## Description

The present invention relates generally to discrete power transistors, and more specifically to transistors for use in power emitter-follower amplification circuits.

Emitter-follower transistors, also known as common-collector transistors, are typically used in small signal applications where a match is needed between a high resistance signal source and a lower resistance load. Although the voltage gain of the emitter-follower is slightly less than unity, the emitter-follower does have substantial current gain, as well as substantial power gain. In addition, the voltage feedback of the load element results in a highly linear transfer characteristic (the dependance of output voltage upon input voltage). The output signal is not inverted and follows almost exactly the input voltage, although the output voltage is offset from the input voltage by a DC level equal to the base-emitter voltage of the transistor. Finally, the emitter-follower is able to deliver its power gain at frequencies nearly up to the unity-gain frequency of the transistor. Because of these properties, the emitter-follower buffer stage is often used in circuits such as oscillators or voltage-controlled oscillators where the oscillator frequency can be altered by direct connection to a low impedance load.

There has been a steady trend in the art towards improvements in transistor performance. Both high power transistors for audio and switching power supplies, and high frequency transistors for ultra high frequency (UHF) and very high frequency (VHF) applications are routinely built. Power transistors suitable for audio applications and switched-mode power supplies typically have the silicon chips mounted directly to the metal flange of the package. Such a mounting procedure results in the best possible heat conduction between the collector-base junction and the package. This type of mounting is characterized by a low thermal resistance of 1 to 3 degrees Celsius/Watt or less.

In the evolution of high frequency power transistors for UHF and VHF, the direct mounting of the silicon die to the heat-sink flange is not typically done for reasons unique to the high frequency applications. Although the requirement of good heat dissipation is still there, having the collector electrically connected to the package results in the addition of substantial parasitic circuit elements such as collector to package capacitance. The addition of parasitic elements can substantially degrade high frequency performance.

Thus, UHF and VHF power transistors electrically isolate the transistor collector from the mounting flange by mounting the transistor die on an insulator such as beryllium oxide (BeO). The BeO insulator itself is then mounted to the device flange. Although the transistor collector is electrically isolated, it still is capable of dissipating its heat to the mounting flange by the conduction of heat through the BeO. The inclusion of BeO as an insulator increases the thermal resistance substantially.

Accordingly, it would be advantageous in the art to have an emitter-follower transistor which is directly mounted to the mounting flange for use in high frequency (UHF or VHF) circuits. The resultant device would provide higher power output than can transistors which employ insulators such as BeO to insulate the collector and would still maintain a safe junction temperatures.

It would be advantageous in the art to use common-collector, also known as emitter-follower, transistors in power amplifier applications. The collector of an emitter-follower transistor is mounted directly to the flange of the transistor. The thermal resistance from junction to case is greatly reduced by eliminating the use of an insulating material between the collector of the emitter-follower transistor and the flange of the device package. Elimination of the insulator also means that in addition to providing greater power saturation, the emitter-follower circuit may also be utilized to deliver a lower power saturation with increased device reliability.

The novel features believed characteristic of the invention are set forth in the appended claims. The invention itself, however, as well as a preferred mode of use, and further objects and advantages thereof, will best be understood by reference to the following detailed description of an illustrative embodiment when read in conjunction with the accompanying drawings, wherein:
**Figure 1** is a schematic of an emitter-follower transistor circuit according to the prior art;
**Figure 2** is a graph illustrating the power gain advantages at power saturation of an emitter-follower transistor according to the present invention;
**Figure 3** is a schematic of an emitter-follower transistor according to the prior art;
**Figure 4** is a schematic of an emitter-follower transistor according to the present invention;
**Figure 5a** is a diagram of a portion of an emitter-follower transistor package according to the prior art;
**Figure 5b** is a schematic of the electrical connection between the emitter-follower circuit die and the flange of the emitter-follower package according to the prior art;
**Figure 6a** is a diagram of a portion of an emitter-follower transistor package according to the present invention;
**Figure 6b** is a schematic of the electrical connection between the emitter-follower circuit die and the flange of the emitter-follower package according to the present invention; and
**Figure 7** is a circuit of Class A emitter-follower transistor stage according to the present invention.

Power gain in traditional emitter-follower transistors has been limited in large part due to the thermal resistance from junction to case (ϑ_{JC}) of the device. When the thermal resistance from junction to case is minimized, the power saturation of the device may be maximized. Lowering thermal resistance allows the benefits associated with the emitter-follower transistor to be enjoyed in power amplification circuitry. At lower temperatures, the same power gain may be achieved, but with improved reliability; or, for a given temperature, a higher power saturation point may be achieved with the same reliability as before. These improvements to the emitter-follower transistor render it desirable for use in high frequency (UHF or VHF) power circuits.

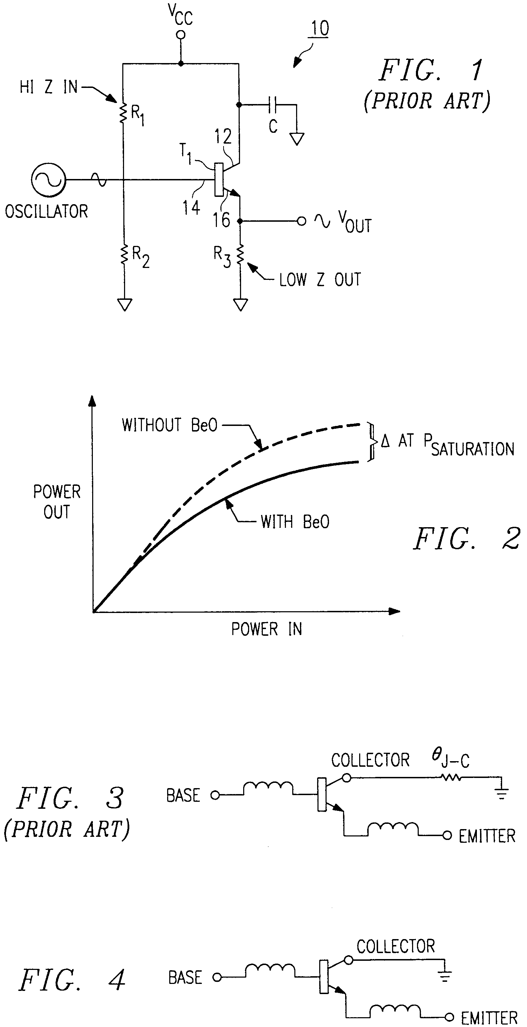

**Figure 1** demonstrates a typical emitter-follower transistor in a small signal oscillator circuit according to the prior art. Amplifier 10 has a signal source OSCILLATOR which provides an input signal to the base of emitter-follower transistor T₁. T₁ has a collector 12, a base 14, and an emitter 16. The collector 12 of T₁ is connected directly to V_{cc}, the collector supply voltage.

High-frequency, microwave power transistors are typically fabricated with their collectors electrically isolated or insulated from the transistor case flange. Even though collector insulators are fabricated from insulators which are relatively good conductors of heat, this does increase the thermal resistance ϑ_{JC}. from the junction to the case of transistor T₁.

ϑ_{JC} is not a physical resistor but instead represents the thermal resistance from the junction to the case of transistor T₁ which is greatly dependent on the collector insulator. Capacitor C performs a bypass function from the collector 12 to AC ground potential. Resistors R₁ and R₂ provide base bias and are selected at high enough values to maintain the high input impedance of the buffer circuit 10. V_{OUT} is the voltage output signal of the circuit.

The presence of thermal resistance, ϑ_{JC}, from junction to case adversely affects the power which can be delivered to the load of an emitter-follower circuit. The following equation describes the well-known relationship between ϑ_{JC} (in degrees C/Watt) and power dissipation, P_{D} in Watts: T_{J} - T_{A} = ΔT = ϑ* P_{D}, where ϑ is equal to ϑ_{JC} **+** ϑ_{CH} + ϑ_{HA}. T_{J} is the temperature at the junction of the device; each transistor has an inherent T_{Jmax} which is dependent upon the materials used to construct it. T_{A} is the ambient temperature, typically 25 degrees C. ϑ_{JC} is the thermal resistance from junction to case, ϑ_{CH} the thermal resistance from the case to the heat sink of the device, and ϑ_{HA} is the thermal resistance from the heat sink of the device to the ambient. Since ϑ_{JC} is the dominant term of the equation, the above equation may be reduced as follows: T_{J} - T_{A} = ΔT = ϑ_{JC} * P_{D}.

This equation may be utilized to demonstrate the adverse affect of ϑ_{JC} upon the power gain of the emitter-follower transistor circuit shown in **Figure 1.** As an example, assume that T_{J} is equal to 200 degrees C, T_{A} is 25 degrees C, and that ϑ_{JC} is equal to 3 degrees C per Watt. P_{D} is equal to 58.33 W delivered to the load. Now suppose the thermal resistance from junction to case, ϑ_{JC}, is drastically reduced from 3 to 0.1 degrees C per Watt; P_{D} is now equal to 1750 W. Simply reducing ϑ_{JC} greatly increases the amount of power output which may be delivered to the load for a given T_{J}. **Figure 2** illustrates the a potential advantage of using the traditional emitter-follower transistor without an insulator such as BeO. The saturated power available with an emitter-follower transistor according to the present invention is much greater than is possible for the emitter-follower transistor which uses an insulator.

In small signal circuits, emitter-follower transistors are normally manufactured using insulators which increase the thermal resistance from junction to case, ϑ_{JC}. **Figure 3** demonstrates the thermal resistance, ϑ_{JC}, which is due in large part to an insulator placed between the collector of the transistor and ground. When the insulator is removed, the value of ϑ_{JC} is eliminated or greatly reduced. This is demonstrated in **Figure 4** where the there is no thermal resistance represented between the collector and ground.

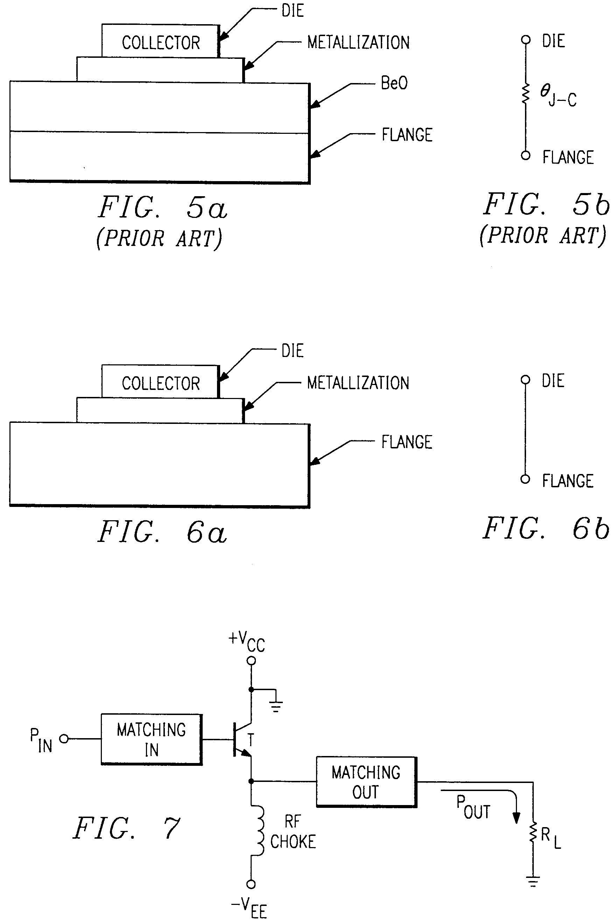

Beryllium Oxide (BeO) is widely used as an insulator between the collector and the package of transistors. **Figure 5a** shows a diagram of a portion of an emitter-follower transistor package according to the prior art. A portion of the die, shown as a collector, rests on metallization which is isolated from the package flange by a layer of BeO insulator. BeO used in this manner increases the thermal resistance from junction to case ϑ_{JC}, an undesirable result as described above. **Figure 5b** shows a schematic of the electrical connection between the emitter-follower circuit die and the flange of the emitter-follower package, and illustrates the increased thermal resistance that results from using an insulator such as BeO.

In the present invention, a collector insulation is not used. The collector is mounted directly to the flange of the package and the portion of an emitter-follower transistor package shown in **Figure 6a** would result. In this package configuration, the collector of the emitter-follower is effectively connected directly to the flange of the package which is ground. **Figure 6b** shows that the electrical connection between the die and the flange has a much smaller ϑ_{JC} than is shown in **Figure 5b.**

**Figure 7** shows a Class A emitter-follower transistor stage according to the present invention. The input power P_{IN} goes to a Matching Input circuit before it goes to the base of emitter-follower transistor T. The Matching Input circuit matches the impedance of the signal source to the base of the transistor T. +V_{CC}, connected to the collector of the transistor, is the positive supply voltage and is connected to ground through the flange. The emitter of transistor T is connected to an RF choke which provides the emitter with the DC power required to turn on transistor T. The emitter is also connected to Matching Output circuit which matches the output impedance of the transistor to the load R_{L}, normally 50 ohms. P_{OUT} is the power delivered to the load.

According to the invention, an emitter-follower stage of a power amplifier circuit may be redesigned to deliver more power to the load for a given maximum device junction temperature or to deliver the same power to the load for a lower device junction temperature. Again assuming an emitter-follower transistor operating in the Class A configuration shown in **Figure 7,** the power dissipated in the driver of the emitter-follower circuit can be greatly increased by lowering ϑ_{JC} for a given junction temperature, T_{J}. For the purposes of this example, T_{J} is 115 degrees C and V_{CC} is 12 volts. By decreasing the value of ϑ_{JC} from 10 degrees C/Watt to 3 degrees C/Watt, the power output saturation point of the emitter-follower T₁ is greatly increased. The power dissipated in the driver increases from 9 to 30 Watts, the power delivered from the supply voltage, V_{CC}, increases from 24 to 80 Watts, and, finally, the power delivered to the load, R_{L}, increases from 6 to 20 Watts. Even though the power output was large, the reliability of the emitter-follower transistor was not adversely affected because T_{J} remained constant at 115 degrees C.

The above example illustrates that lowering ϑ_{JC} while maintaining the same junction temperature T_{J} can result in a higher power output. The emitter-follower Class A transistor may also be redesigned to have a lower junction temperature T_{J} for a given power gain by lowering ϑ_{JC}. In this example, elimination of BeO as an insulator again lowers ϑ_{JC} from 10 to 3 degrees C/Watt. The power dissipated in the driver is held constant at 9 Watts. The device operates at a much cooler temperature as a result; T_{J} drops from 115 degrees C to 52 degrees C. The collector of the transistor is mounted directly to the heat sink or flange of the package and so the heat sink is much more effective at dissipating heat away from the device. Delivering the same power at a lower T_{J} means that operation of the device is much more reliable.

**Figure 7** illustrates a preferred embodiment according to the present invention. It offers the advantages of a higher power saturation or increased reliability when the thermal resistance ϑ_{JC} is lowered by eliminating the insulator material between the collector and the flange of the transistor case. Increased power output in emitter-follower transistor stages means that they may be utilized in power amplifier circuits such as high frequency RF and microwave power applications.

While the invention has been particularly shown and described with reference to a preferred embodiment, it will be understood by those skilled in the art that various changes in form and detail may be made therein without departing from the spirit and scope of the invention.

## Claims

1. A transistor having improved thermal resistance characteristics capable of enhanced power saturation for use in power emitter-follower amplification circuits, comprising:
an emitter-follower transistor die having a base, an emitter, and a collector;
a package casing, having a flange, which houses the die; and
means for reducing the emitter-follower transistor thermal resistance from the transistor die to the package casing so that the emitter-follower transistor may be utilized in power amplification circuitry.

2. The emitter-follower transistor of claim 1, wherein the reducing means is accomplished by having no insulator present to insulate the transistor die from the package casing.

3. The reducing means of claim 2, wherein the collector of the transistor die is mounted directly to the flange of the package casing.

4. The emitter follower transistor of claim 3, wherein the collector and the flange of the package casing have the same voltage potential.

5. The emitter-follower transistor of claim 4, wherein the power amplification circuitry is characterized as circuitry wherein power gain is required.

6. The emitter-follower transistor of claim 5, wherein the power amplification circuitry is radio frequency (RF) power circuitry.

7. The emitter-follower transistor of claim 5, wherein the power amplification circuitry is microwave power circuitry.

8. The emitter-follower transistor of claim 4, wherein the emitter-follower transistor is in the Class A configuration.

9. The emitter-follower transistor of claim 8, wherein the Class A transistor is characterized by a high impedance source and a low impedance load.

10. The emitter-follower transistor of claim 4, wherein the voltage potential is zero volts.

11. The emitter follower transistor of claim 2, wherein the insulator which is not present is Beryllium Oxide (BeO).
